(19) Europäisches Patentamt
European Patent Office
Office européen des brevets

(11) **EP 0 836 277 B1**

(12) **EUROPEAN PATENT SPECIFICATION**

(45) Date of publication and mention
of the grant of the patent:
**13.06.2007  Bulletin 2007/24**

(51) Int Cl.:
***H03H 7/01*** *(2006.01)*

(21) Application number: **97116464.5**

(22) Date of filing: **22.09.1997**

(54) **LC composite part**

LC-Kompositbauteil

Dispositif LC composite

(84) Designated Contracting States:
**DE FR GB**

(30) Priority: **14.10.1996  JP  27083196**
**14.10.1996  JP  27083396**
**14.10.1996  JP  27083496**

(43) Date of publication of application:
**15.04.1998  Bulletin 1998/16**

(73) Proprietor: **MITSUBISHI MATERIALS CORPORATION**
**Chiyoda-ku,**
**Tokyo (JP)**

(72) Inventor: **Kitahara, Naoto,**
**c/o Electronics Techn. Res. C.**
**Yokozemachi,**
**Chichibu-gun,**
**Saitama-ken (JP)**

(74) Representative: **von Fischern, Bernhard et al**
**Hoffmann - Eitle,**
**Patent- und Rechtsanwälte,**
**Arabellastrasse 4**
**81925 München (DE)**

(56) References cited:
**US-A- 4 904 967**      **US-A- 5 532 656**

• **PATENT ABSTRACTS OF JAPAN vol. 1996, no.**
**06, 28 June 1996 (1996-06-28) & JP 08 031695 A**
**(MURATA MFG CO LTD), 2 February 1996**
**(1996-02-02)**

**Description**

BACKGROUND OF THE INVENTION

Field of the Invention

The present invention relates to an LC composite part constituted by forming inductor and capacitor at inside of a substrate including both of a magnetic material and a dielectric material.

Description of the Related Art

Conventionally, an EMI (Electro Magnetic Interference) filter has been used as a countermeasure for high frequency noise in an electronic device. Generally, an EMI filter is constituted by combining individual elements of condensers and inductors and many types of EMI filters constituted by combinations of the individual elements have been proposed. As representative ones, for example, there have been known an EMI filter of an L type constituted by combining one capacitor and one inductor and an EMI filter of a n type constituted by combining two capacitors and one inductor and countermeasure against noise of an electronic device has been carried out by using the EMI filters.

When an EMI filter is constituted by combining respective individual elements of capacitors and inductors in this way, a total of the EMI filter is magnified, a wide area is needed in attaching the EMI filter to a circuit board or the like and a number of steps are required in combining individual elements.

In recent years, there have been proposed filters resolving the problems and incorporating capacitors and inductors in a single chip (refer to Japanese Unexamined Patent Publication No. JP-A-8-65080, Japanese Unexamined Patent Publication No. JP-A-8-148381).

According to the publications, there has been proposed a filter part in a chip-like shape where conductive films operating as inductors and capacitors are formed on respectives of a plurality of layers each comprising a mixture of a dielectric material and a magnetic material and the plurality of layers are laminated and sintered thereby forming an LC filter of an L type or a π type at inside thereof.

All of inductors formed at inside of the filter part described in the publications, are of a type where linear conductive films are sandwiched by mixtures each comprising a dielectric material and a magnetic material and it is difficult to provide large inductance in limited dimensions.

Further LC composite parts are disclosed in JP 08 031 695 A, in US 4 904 967 A or in US 5 532 656 A.

It is conceivable for obtaining large inductance to form an inductor of a spiral structure extending over a plurality of layers by forming half rounding or full rounding conductive films on a single layer comprising a mixture of a dielectric material and a magnetic material, which are extended to a next layer via conductors in through holes, followed by making a half turn or one turn on the layer. The inventors have carried out trial fabrication on the basis of the way of thinking. When such an inductor having a spiral structure is simply formed in a mixture substrate, the magnetic force effects adverse influence on a capacitor contiguous to the inductor at inside of the substrate whereby the characteristic is significantly deteriorated.

Further, although a multi stage type of LC filter circuit is preferably constituted in order to constitute an LC filter circuit having excellent filter characteristic, when a multi stage type LC filter circuit is intended to constitute by applying as they are the LC filter circuit of an L type and the LC filter circuit of a π type which have been proposed in the above-mentioned literatures, dimensions are excessively enlarged to provide large inductance which is not practical.

Further, when the mixture of a dielectric material and a magnetic material is adopted, since the dielectric material is included, the inductor formed at inside thereof is provided with a considerably large residual capacitor that is equivalently connected to the inductor in parallel therewith and accordingly, an LC filter circuit having excellent characteristic is difficult to obtain.

SUMMARY OF THE INVENTION

It is an object of the present invention to provide an LC composite part by forming inductors in a spiral structure and capacitors in the same substrate and yet restraining adverse influence on the capacitors caused by magnetic fields which are generated by the inductors.

It is other object of the present invention to provide an LC composite part where an LC filter circuit of a multi stage type is formed in limited dimensions.

Further, it is still other object of the present invention to provide an LC composite part capable of providing excellent filter characteristic even with presence of a residual capacitor.

The invention is defined in the claims. According to a first aspect of the present invention, there is provided a first LC composite part comprising a substrate including both of a magnetic material and a dielectric material, inductors formed at an inside of the substrate having two spiral structures arranged with each other and connected to each other such that magnetic fluxes at insides of the spiral structures are in parallel with each other and directed in mutually reverse directions, and capacitors comprising plane plates in parallel with each other formed at the inside of the substrate.

According to the first aspect of the LC composite part of the present invention, the inductors having two spiral structures are provided such that the magnetic fluxes at insides of the spiral structures are in parallel with each other and directed in reverse directions and accordingly, a magnetically closed circuit is formed where, even if the capacitors are arranged at locations other than passages of the magnetic fluxes, almost no influence of the magnetic field is effected whereby a circuit having a desired characteristic can be formed in the substrate. The capacitors are formed at positions sandwiched by the two spiral structures constituting inductors in the first LC composite part of the present invention. When the capacitors are formed at the positions sandwiched by the two spiral structures in this way, loss of space is avoided, which contributes to downsizing the part.

Also, according to the first LC composite part of the present invention, ones of the parallel planer plates constituting capacitors may be connected to intermediate positions of the inductors. Here, the intermediate position needs not to be located at the center but signifies a position somewhere at the midway of the inductor.

By the connection to the intermediate positions, a desired filter circuit can be constituted.

Further, according to a second aspect of the present invention, there is provided a second LC composite part having the features of the first LC composite part and comprising a first and a second terminal electrode formed on external faces of the substrate, ground electrodes formed on the external faces of the substrate, inductors formed at an inside of the substrate, arranged between the first terminal electrode and the second terminal electrode and comprising conductor films formed in a spiral shape extending over a plurality of layers, and two or more of capacitors formed at the inside of the substrate and arranged between intermediate points of the inductors respectively different from each other and the ground electrodes.

According to the second LC composite part of the present invention, the inductors comprising the conductive films formed in a spiral shape extending over the plurality of layers, are provided and therefore, the inductors having large inductances can be formed with small dimensions. Also, according to the second LC composite part of the present invention, the substrate is a mixture of a dielectric material and a magnetic material and therefore, the capacitors may be formed at the intermediate points of the inductors, that is, at the midway of the conductive films constituting the inductors and accordingly, an LC filter circuit of a multi stage type can be formed with small dimensions.

According to a third aspect of the present invention, there is provided a third LC composite part having the features of the first LC composite part and wherein the inductors and capacitors constitute a low pass LC filter circuit, and wherein when a cut off frequency of the LC circuit is designated by a notation fc, an inductance of one of the inductors is designated by a notation L and a capacitance of one of the inductors as a residual capacitor equivalently connected to one of the inductors in parallel is designated by a notation C, the residual capacitor is provided with the capacitance satisfying the following equation;

$$\log(fc) + 0.6 \leq \log\{1/2(2\pi\sqrt{(LC)}\}$$
$$\leq \log(fc) + 1.5 \qquad \ldots\ldots(1).$$

Here, in the case of

$$\log(fc) + 1.5 \leq \log\{1/(2\pi\sqrt{(LC)})\},$$

the attenuation coefficient is decreased and therefore, the filter characteristic is deteriorated, which is not preferable.

Further, in the case of $\log\{1/(2\pi\sqrt{(LC)})\} < \log(fc) + 0.6,$ although it is theoretically preferable in view of the insertion loss characteristic, a material having extremely small loss is needed and therefore, it is impossible with an actually available material. Incidentally, the dielectric loss of a currently available material is substantially 0.03 and the magnetic loss is substantially 0.5.

## BRIEF DESCRIPTION OF THE DRAWINGS

Fig. 1 is a disassembled perspective view common to an embodiment of a first, a second and a third LC composite part according to the present invention;

Fig. 2 is an outlook view common to the embodiment of the first, the second and the third LC composite parts according to the present invention;

Fig. 3 is an equivalent circuit diagram common to the embodiment of the first and the second LC composite parts according to the present invention;

Fig. 4 is a schematic arrangement view of a filter circuit having the structure shown by Fig. 1;

Fig. 5 is a schematic view showing a magnetic field extending over two spiral structures ;

Figs. 6A and 6B are views showing a first step in respective fabrication steps of the LC composite part shown by the disassembled perspective view of Fig. 1;

Figs. 7A and 7B are views showing a second step in respective fabrication steps of the LC composite part shown by the disassembled perspective view of Fig. 1;

Figs. 8A and 8B are views showing a third step in respective fabrication steps of the LC composite part shown by the disassembled perspective view of Fig. 1;

Figs. 9A and 9B are views showing a fourth step in respective fabrication steps of the LC composite part shown by the disassembled perspective view of Fig. 1;

Figs. 10A and 10B are views showing a fifth step in respective fabrication steps of the LC composite part shown by the disassembled perspective view of Fig. 1;

Figs. 11A and 11B are views showing a sixth step in respective fabrication steps of the LC composite part shown by the disassembled perspective view of Fig. 1;

Figs. 12A and 12B are views showing a seventh step in respective fabrication steps of the LC composite part shown by the disassembled perspective view of Fig. 1;

Figs. 13A and 13B are views showing an eighth step in respective fabrication steps of the LC composite part shown by the disassembled perspective view of Fig. 1;

Figs. 14A and 14B are views showing a ninth step in respective fabrication steps of the LC composite part shown by the disassembled perspective view of Fig. 1;

Fig. 15 is a disassembled perspective view of an LC composite part having only a single spiral structure which is not in accordance with the invention;

Fig. 16 is a schematic arrangement view of the LC composite part shown by Fig. 15;

Fig. 17 is a schematic view showing a magnetic field having a spiral structure in respect of the LC composite part shown by Fig. 15;

Fig. 18 is a diagram showing experimental data of the filter characteristic of the filter having left and right two windings spiral structures shown by Fig. 1 and the filter characteristic of the filter having a central one winding spiral structure shown by Fig. 15;

Fig. 19 is a diagram showing experimental data of filter characteristics of LC filter circuits of a one layer product, a three layer product, a five layer product and a seven layer product; and

Fig. 20 is an equivalent circuit diagram of one embodiment of a third LC composite part according to the present invention.

## DETAILED DESCRIPTION OF THE PREFERRED EMBODIMENTS

An explanation will be given of embodiments of the present invention as follows.

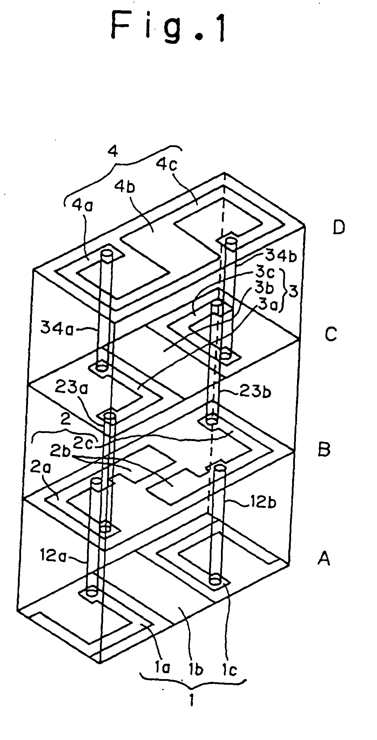

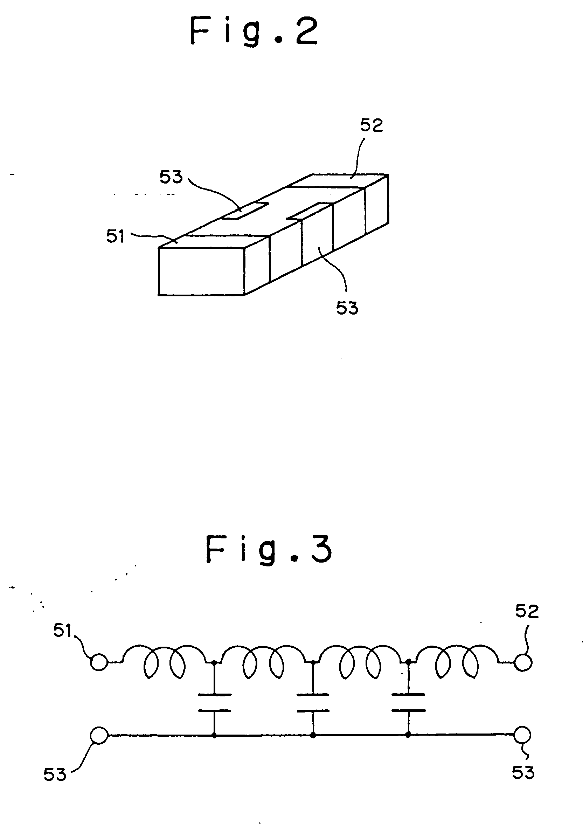

Fig. 1 is a disassembled perspective view common to respective embodiments of a first, a second and a third LC composite part according to the present invention, Fig. 2 is an outlook view thereof and Fig. 3 is an equivalent circuit diagram common to the embodiments of the first and the second LC composite parts. Here, an explanation will firstly be given of the embodiment of the first LC composite part according to the present invention and thereafter, an explanation will be given of the embodiments of the second and the third LC composite parts according to the present invention. Incidentally, an explanation will be given later of an equivalent circuit diagram of the embodiment of the third LC composite part according to the present invention.

The LC composite part shown by Fig. 1 and Fig. 2, are constituted by four layers where conductive films 1, 2, 3 and 4 are formed on respective layers each comprising a mixture of a dielectric material and a magnetic material. The conductive films 1 ,2, 3 and 4 are respectively conductive films of a first layer A, a second layer B, a third layer C and a fourth layer D. The conductive films constituting contiguous layers in the up and down direction are electrically connected by conductors at insides of through holes 12a, 12b; 23a, 23b; 34a, 34b.

Here, conductive films each having a spiral structure are respectively formed by conductive films 1a, 2a, 3a, 4a; 1c, 2c, 3c, and 4c at both sides extending over the four layers and they are spiraled in mutually reverse directions and connected to each other via a conductive film 4b of the fourth layer. Further, capacitors are formed by conductive films 1b, 2b, 3b and 4b at central portions of the four layers. Thereby, a multi stage type LC filter circuit shown by an equivalent circuit of Fig. 3 is formed as a whole.

In this case, the conductive films 1a and 1c of the first layer are exposed from end faces of a substrate constituted by laminating the respective layers by which both terminals of the spiral structure are respectively connected to a terminal electrode 51 and a terminal electrode 52 shown by Fig. 2, and the central conductive film 1b of the first layer and the central conductive film 3b of the third layer are exposed from side faces of the substrate by which the conductive films 1b and 3b are connected to ground electrodes 53 shown by Fig. 2.

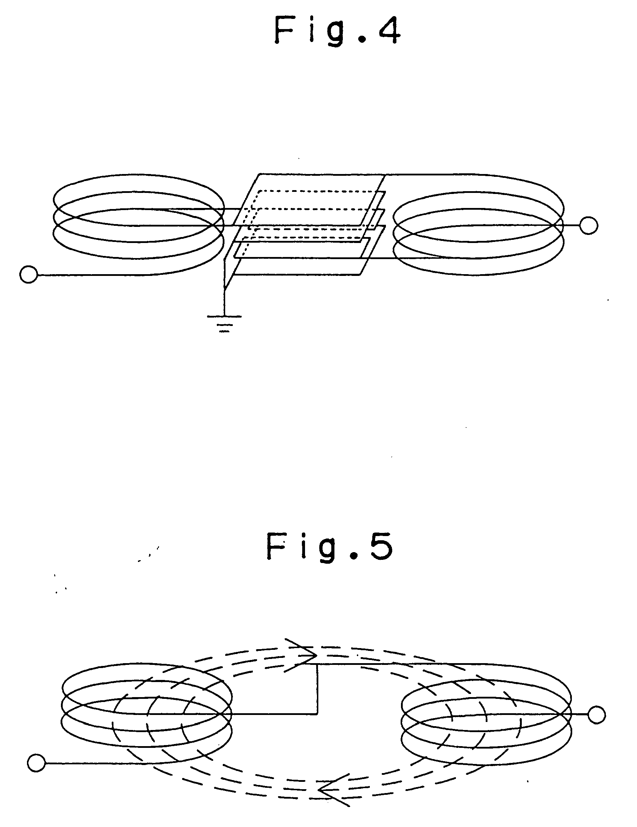

Fig. 4 is a schematic arrangement view of the filter circuit having the structure shown by Fig. 1 and Fig. 5 is a schematic view showing a magnetic field extending over two spiral structures.

As shown by Fig. 4, the filter circuit having the structure shown by Fig. 1 is provided with inductors each having a spiral structure at both sides thereof and capacitors are provided at the center of the two spiral structures. According to the two spiral structures, spirals in mutually reverse directions are formed and accordingly, magnetic fluxes at insides of the two spiral structures are in parallel to each other and directed in mutually reverse directions by which a magnetically closed circuit shown by Fig. 5 is formed as a whole. Therefore, almost no magnetic field operates at portions of the capacitors arranged at the central portion of the two spiral structures and these capacitors can achieve desired characteristics as they are without receiving adverse influence caused by the magnetic field.

Further, since the magnetically closed circuit is formed between the two spiral structures, magnetic fluxes leaking outside of the electronic circuit part are extremely weak and even if other circuit element is arranged at proximity of the electronic circuit part, almost no magnetic field operates on the circuit element.

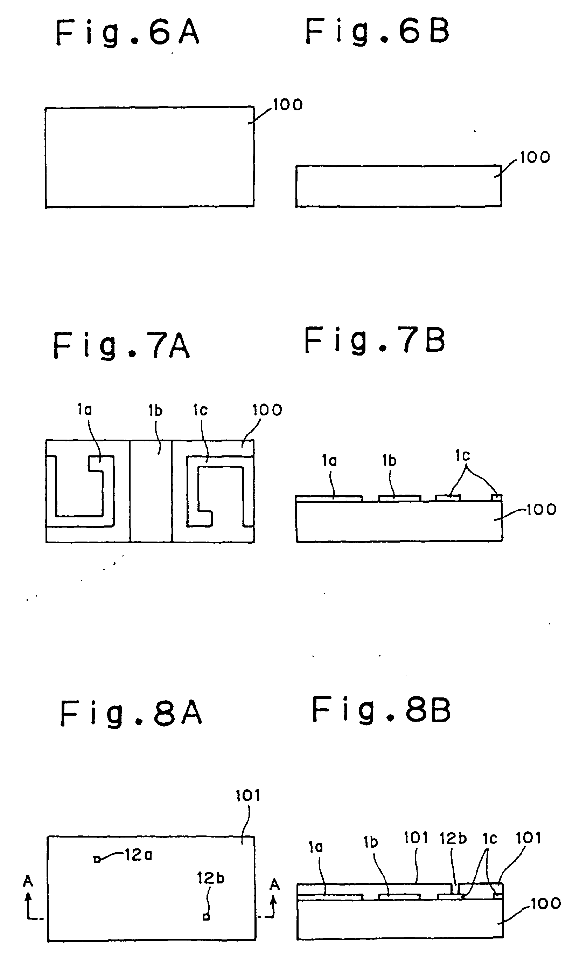

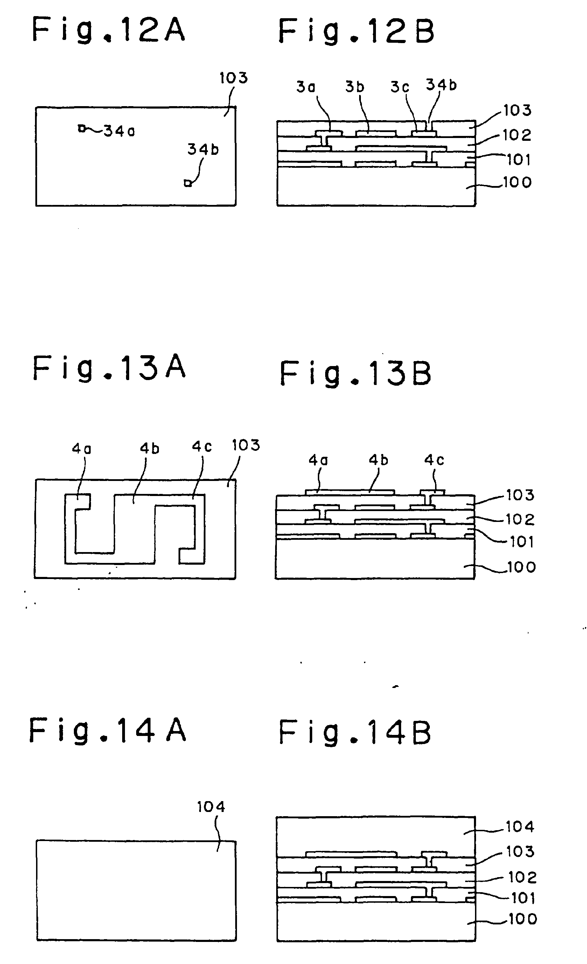

Fig. 6A, Fig. 6B through Fig. 14A, Fig. 14B are views showing respective fabrication steps of the LC composite part shown by the disassembled perspective view of Fig. 1. Fig. 6A, Fig. 7A, Fig. 8A, ..., Fig. 14A are plane views and Fig. 6B ,Fig. 7B, Fig. 8B, ...,Fig. 14B are sectional views taken along an arrow mark A-A as representatively shown in Fig. 8A.

In this embodiment, a paste mixed with a dielectric body and a magnetic body is formed by mixing in a pertinent rate a magnetic calcinated powder which is formed by mixing and calcinating a magnetic material having a major component of, for example, Ni-Zn ferrite and crushing the material to constitute a pertinent particle size and a dielectric calcinated powder that is formed by mixing and calcinating a dielectric material having a major component of, for example, $PbTiO_3$ and crushing the material to constitute a pertinent particle size and adding a dispersant, a binder, a plasticiser, a solvent and the like. As explained below, the paste mixed with a dielectric body and a magnetic body fabricated as described above, and a conductive paste having a major component of Ag or Pd are alternately laminated by performing a screen printing and cutting the assemblage as necessary thereby forming a green laminated body. The laminated body is subjected to a binder removing treatment and is further sintered to form a sintered body. The terminal electrodes 51 and 52 and the ground electrodes 53 (refer to Fig. 2) are formed on the sintered body by using a conductive paste or the like having a major component of, for example, Ag. In this way, the LC composite part is finished.

Hereinafter, an explanation will be given of respective fabrication steps of the LC composite part shown by Fig. 1 in reference to the respective drawings.

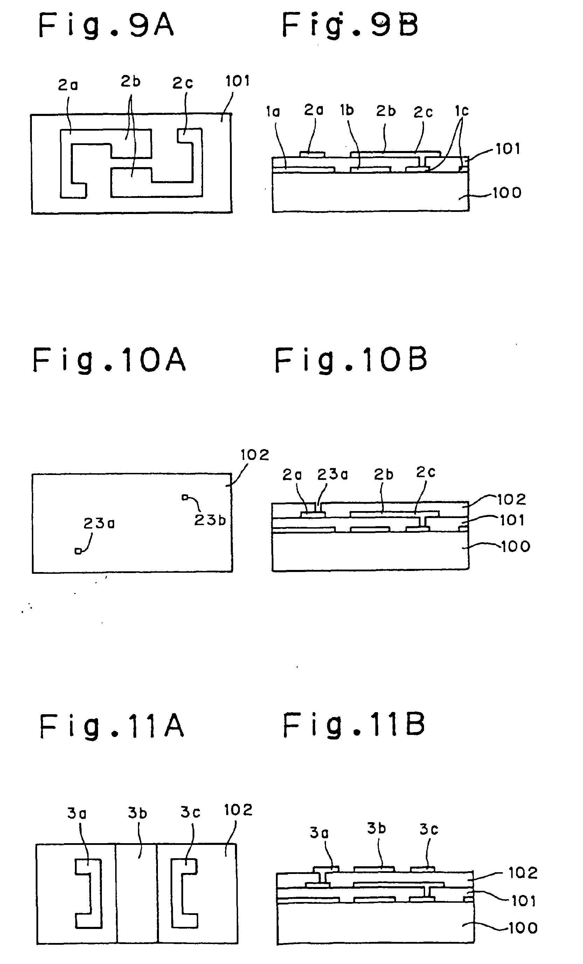

First, as shown by Fig. 6A and Fig. 6B, a base substrate 100 comprising the paste mixed with a dielectric material and a magnetic material which has been fabricated as described above, is formed and the conductive films 1a, 1b and 1c of the first layer are formed on the base substrate 100 by screen printing of a conductive paste (Fig. 7A and Fig. 7B). Further, a layer 101 mixed with a dielectric material and a magnetic material is formed by screen-printing the paste mixed with the dielectric material and the magnetic material such that through holes 12a and 12b are formed (Fig. 8A and Fig. 8B). Similarly, the conductive films 2a, 2b and 2c of the second layer are formed by the conductive paste (Fig. 9A and Fig. 9B). At this occasion the conductive paste is filled also in the through holes 12a and 12b by which electric connection of the conductive films of the second layer to the conductive films of the first layer is performed. Furthermore, a layer 102 mixed with the dielectric material and the magnetic material is formed thereon such that through holes 23a and 23b are formed (Fig 10A and Fig. 10B) on top of which the conductive films 3a and 3b and 3c of the third layer are formed (Fig. 11A and Fig. 11B). A layer 103 mixed with the dielectric material and the magnetic material is formed thereon such that through holes 34a and 34b are formed (Fig. 12A and Fig. 12B), on top of which the conductive films 4a and 4b and 4c of the fourth layer are formed (Fig. 13A and Fig. 13B), on top of which a base substrate 104 is formed. The conductive paste is filled in the through holes 23a, 23b, 34a and 34b similar to the through holes 12a and 12b.

After forming such a laminated body, as mentioned above, the laminated body is subjected to a binder removing treatment, and is sintered further to form a sintered body. The terminal electrodes 51 and 52 and the ground electrodes 53 are formed at continuously connected external faces of the sintered body as shown by Fig. 2.

The LC composite part having the structure shown by Fig. 1 and Fig. 2 is fabricated after being processed through such fabrication steps.

Here, a further multi stage filter circuit can be constituted by repeating the above-described fabrication steps, specifically, from the step shown by Fig. 8A and Fig. 8B to the step shown by Fig. 11A and Fig. 11B.

In the following, the LC composite part having two spiral structures at inside thereof shown by Fig. 1 which is in accordance with the invention, is compared with an LC composite part having only one spiral structure at inside thereof which is not in accordance with the invention.

In the following description, an explanation will be given of the structure of the LC composite part having only one spiral structure at inside thereof and successively, the LC composite part is compared with the LC composite part having the structure shown by Fig. 1.

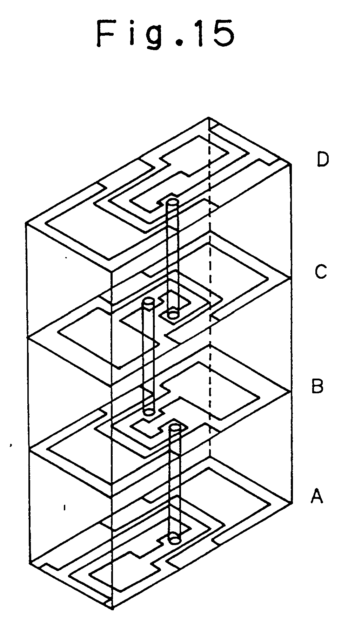

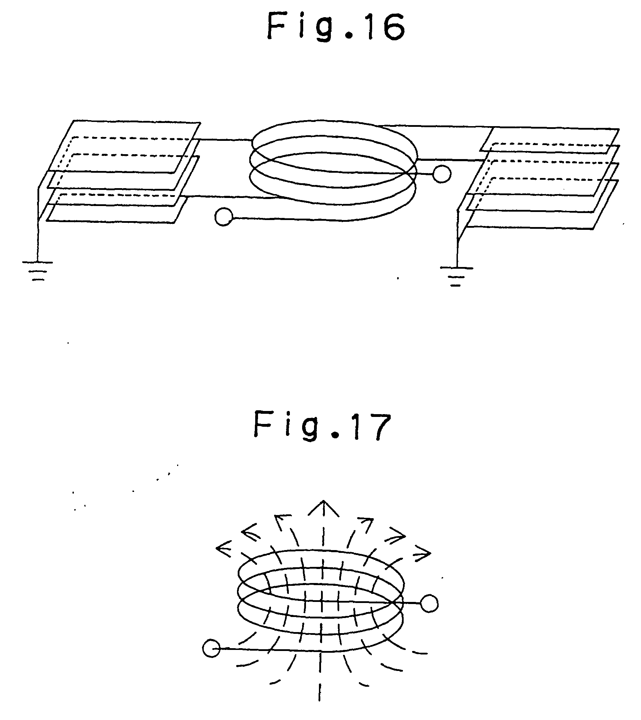

Fig. 15 is a disassembled perspective view of an LC composite part having only one spiral structure at inside thereof, Fig. 16 is a schematic arrangement view of a filter circuit using the LC composite part and Fig. 17 is a schematic view showing a magnetic field having a spiral structure in respect of the LC composite part shown by Fig. 15.

Patterns of conductive films and positions of through holes of the LC composite part shown by Fig. 15 are different from those in the LC composite part shown by Fig. 1. Thereby, as shown by Fig. 16, an inductor having a spiral structure is formed at a central portion thereof and capacitors are formed at both sides thereof. Incidentally, the appearance and the equivalent circuit thereof are the same as the appearance (refer to Fig 2) and the equivalent circuit (refer to Fig. 3) of the LC composite part shown by Fig. 1 .

In the case of the structure shown by Fig. 15 , as shown by Fig. 17, a magnetic field formed by the inductor having a spiral structure, effects as it is an influence on capacitors contiguous to the inductor.

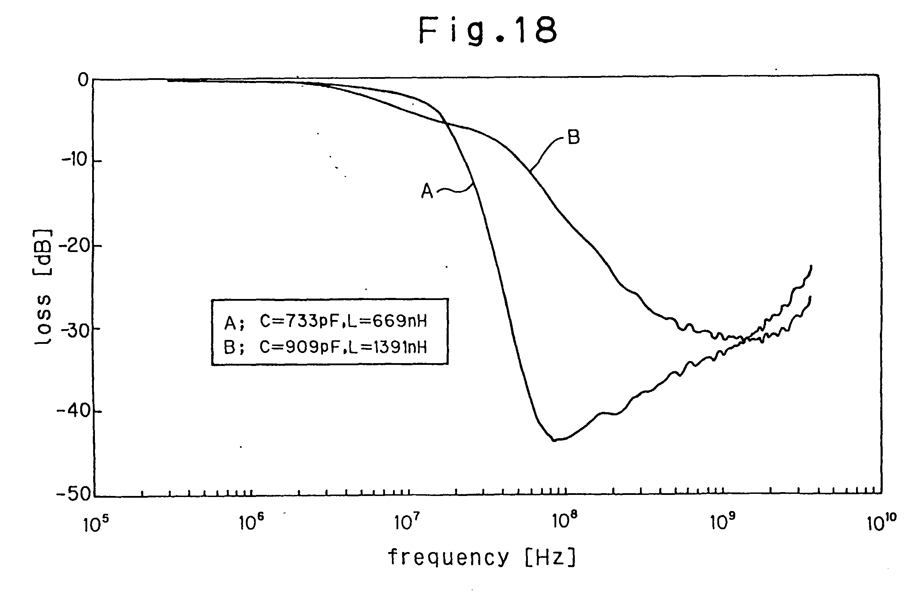

Fig. 18 is a diagram showing experimental data of the filter characteristic A of the filter having left and right two winding spiral structures shown by Fig. 1 and the filter characteristic B of the filter having a central one winding spiral structure shown by Fig. 15.

In this case, the following experimental conditions have been adopted.

(a) Material composition; Ni-Zn-Cu group ferrite: $PbTiO_3$ group dielectric = 6:4 (weight ratio)

(b) Conductive material ; Ag/Pd

(c) Layer thickness ; $12\mu m$

(d) Inductor ; inner sectional area of 0.71 $mm^2$, line width of 0.20mm

(e) Capacitor ; opposed electrode area of 0.64$mm^2$ (per layer)

(f) In the above-described fabrication steps, the steps of from the step shown by Fig. 8A and 8B to the step shown by Fig. 11A and Fig. 11B are repeated twice. That is, the second layers and the third layers shown by Fig. 1 and Fig. 15 are alternately doubled.

Under the above-described conditions, an LC composite part having the structure shown by Fig. 1 and an LC composite part having the structure shown by Fig. 15 (however, the number of layers are larger than those of the respectives shown by Fig. 1 and Fig. 15), have been constructed and the characteristics of these have been measured. As a result, the attenuation coefficient is 37.1dB/dec. in the case of the LC composite part having the structure shown by Fig. 1 and 14.4dB/dec. in case of the LC composite part having the structure shown by Fig. 15 whereby the characteristic can be significantly improved. It seems that this is due to the fact that influence effected on the capacitors is significantly reduced by forming the magnetically closed circuit.

Next, an explanation will be given of an embodiment of the second LC composite part according to the present invention.

According to the embodiment of the second LC composite part, similar to the above-described first LC composite part, Fig. 1 through Fig. 14B are referred to as they are and the explanation which has been carried out in reference to the respective drawings of Fig. 1 through Fig. 14B, is applicable thereto as it is and accordingly, a duplicated explanation will be omitted.

In the following, the filter characteristic of the second solid LC composite part (three layer product, five layer product, seven layer product, mentioned later) each having a plurality of layers mixed with a dielectric material and a magnetic material and having inductors comprising conductive films formed in a spiral shape extending over the plurality of layers as shown by Fig. 1, is compared with the filter characteristic of an LC composite part (one layer product, mentioned later) having only one layer mixed with a dielectric material and a magnetic material and having an inductor comprising conductive films formed in a spiral shape on the layer.

When a pair of one conductor and one capacitor is enumerated as one layer component of a filter circuit as shown by Fig. 3, the second LC composite part having the structure shown by Fig. 1 is constituted by "three layers + one inductor", which is referred to as a "three layer product". Similarly, LC filters having one, five and seven capacitors are respectively referred to as "one layer product", "five layer product" and "seven layer product". The "one layer product", the "five layer product", and the "seven layer product" can be formed by omitting the steps of from the step of Fig. 8A and Fig. 8B to the step of Fig. 11A and Fig. 11B among the respective steps shown from Fig. 6A and Fig. 6B through Fig. 14A and Fig. 14B (case of one layer product), or repeating twice the steps from the step of Fig. 8A and Fig. 8B to the step of Fig. 11A and Fig. 11B (case of five layer product) or repeating three times thereof (case of seven layer product). In this case, LC filter parts having almost the same dimensions are constituted even if the number of layers is increased.

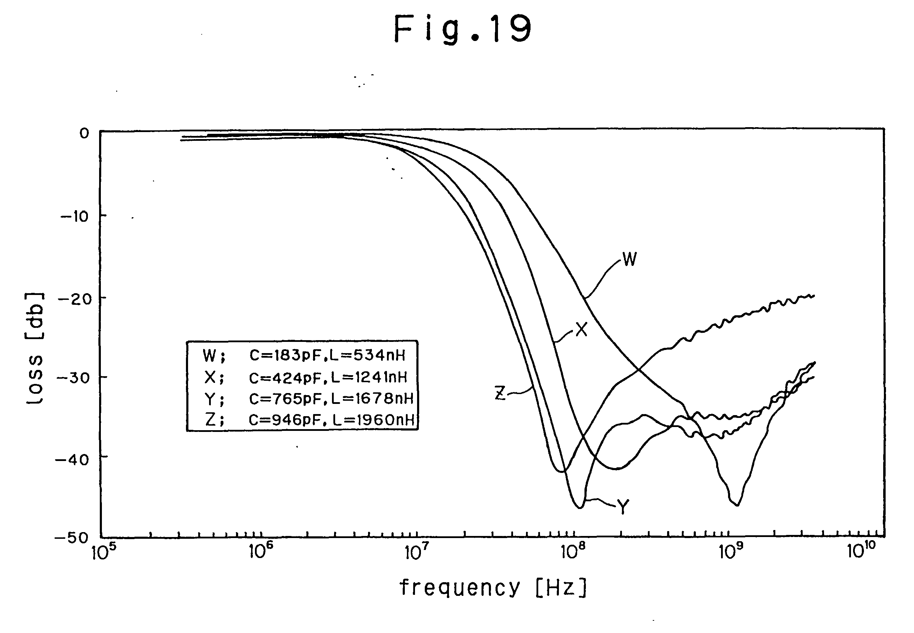

Fig. 19 is a diagram showing experimental data of the filter characteristics of the LC filter circuits of a one layer product W, a three layer product X , a five layer product Y and a seven layer product Z which are fabricated as described above.

In this case, the following experimental conditions have been adopted.

(a) Material composition; Ni-Zn-Cu group ferrite: $PbTiO_3$ group dielectric =6:4 (weight ratio)
(b) Conductive material; Ag/Pd
(c) Layer thickness ; $12\mu m$
(d) Inductor; inner sectional area of $0.71mm^2$, line width of 0.20mm
(e) Capacitor ; opposed electrode area of $0.64mm^2$ (per layer)

Under the above-described conditions, the LC composite parts basically having the structure shown by Fig. 1 and different numbers of layers, have been fabricated and the characteristics have been measured. As a result, as shown by Fig. 19, the LC filter circuits having steeper attenuation characteristics in accordance with an increase in the number of layers are formed. The attenuation coefficients in respect of the respective numbers of layers are, one layer product; 25.8dB/dec., three layer product; 34.9dB/dec., five layer product ;37.1dB/dec., seven layer product 38.8dB/dec.

Next, an explanation will be given of an embodiment of a third LC composite part.

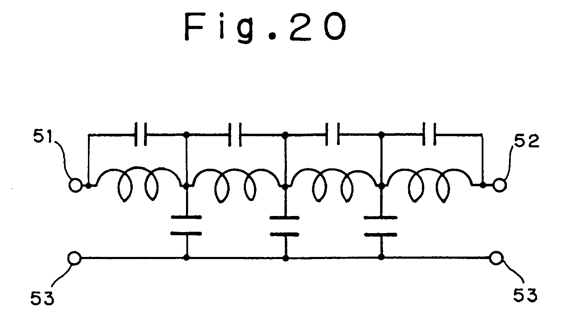

In respect of the third LC composite part, the drawings of Fig. 1 through Fig. 14B except Fig. 3 are referred to as they are and Fig. 20 explained below is referred to in place of Fig. 3. The explanation which has been carried out in reference to Fig. 1, Fig. 2, Fig. 4 through Fig. 14B is applicable as it is also to the third LC composite part. An explanation will be given of Fig. 20 that is the only difference therefrom as follows and thereafter, an explanation will be given of a characteristic point of the third LC composite part.

Fig. 20 is an equivalent circuit diagram of the embodiment of the third LC composite part according to the present invention.

According to the equivalent circuit shown by Fig. 20, capacitors are arranged in parallel with the respective inductors of the equivalent circuit shown by Fig. 3. The capacitors are residual capacitors of the inductors.

Here, the third LC composite part represented by the equivalent circuit of Fig. 20, satisfies the above-mentioned Equation (1) by adjusting the line widths and the like of the conductive films 1a, 2a, 3a, 4a; 1c, 2c, 3c, 4c constituting the inductors in which a low pass LC filter circuit showing an extremely sharp attenuation characteristic is constituted.

Further, in respect of the fabrication steps of the above-described third LC composite part, similar to the first and the second LC composite parts, Fig. 6A and Fig.6B through Fig. 14A and Fig. 14B are referred to as they are. The characteristic points in fabricating the third LC filter part reside in that the material of the paste mixed with a dielectric material and a magnetic material, the thickness of screen printing of the paste mixed with the dielectric material and the magnetic material, the line widths of screen printing of the conductive paste are adjusted such that the residual capacitors of the inductor are adjusted to satisfy Equation (1).

As has been explained, according to the present invention, an LC composite part incorporating capacitors and inductors having a spiral structure preventing adverse influence on the capacitors, is constituted.

Further, according to the present invention, a small-sized LC composite part incorporating a multi stage type LC filter circuit is constituted.

Further, according to the present invention, an LC composite part having excellent filter characteristic by positively utilizing residual capacitors can be provided.

**Claims**

1. An LC composite part comprising :

   a substrate including both of a magnetic material and a dielectric material;
   inductors formed at an inside of the substrate having two spiral structures arranged with each other and connected to each other such that magnetic fluxes at insides of the spiral structures are in parallel with each other and directed in mutually reverse directions; and
   capacitors comprising plane plates in parallel with each other formed at the inside of the substrate, wherein the capacitors are formed at positions sandwiched by the two spiral structures constituting the inductors.

2. The LC composite part according to Claim 1, wherein ones of the plane plates in parallel with each other constituting the capacitors are connected to intermediate positions of the inductors.

3. The LC composite part according to Claim 1, further comprising:

a first and a second terminal electrode formed on external faces of the substrate;
ground electrodes formed on the external faces of the substrate;

wherein
the inductors are formed at an inside of the substrate, arranged between the first terminal electrode and the second terminal electrode and comprising conductor films formed in a spiral shape extending over a plurality of layers; and
two or more of capacitors are formed at the inside of the substrate and arranged between intermediate points of the inductors different from each other and the ground electrodes.

4. The LC composite part according to Claim 1, wherein:

the inductors and capacitors constitute a low pass LC filter circuit; and
when a cut off frequency of the LC circuit is designated by a notation fc, an inductance of one of the inductors is designated by a notation L and a capacitance of one of residual capacitors per inductor equivalently connected to one of the inductors in parallel is designated by a notation C, the residual capacitor is provided with the capacitance satisfying the following:

$$\log(fc) + 0.6 \leq \log\{1/2 \ (2\pi\sqrt{(LC))}\} \leq \log(fc) + 1.5.$$

## Patentansprüche

1. Ein LC-Verbundteil, umfassend:

ein Substrat mit sowohl einem magnetischen Material und einem dielektrischen Material;
Induktoren, die gebildet werden an einer Innenseite des Substrats mit zwei Spiralstrukturen, die miteinander angeordnet sind und miteinander verbunden sind, so dass magnetische Flüsse im Inneren der Spiralstrukturen parallel zueinander sind und in gegenseitig entgegengesetzte Richtungen gerichtet sind; und
Kondensatoren, umfassend ebene Platten, parallel zueinander, die im Innern des Substrats gebildet werden, wobei die Kondensatoren gebildet werden bei Positionen, die durch die zwei Spiralstrukturen, die die Induktoren darstellen, von unten und oben begrenzt werden.

2. Das LC-Verbundteil nach Anspruch 1, wobei eine der ebenen Platten, parallel zueinander, darstellend die Kondensatoren, verbunden werden zu Zwischenpositionen der Induktoren.

3. Das LC-Verbundteil nach Anspruch 1, ferner umfassend:

eine erste und eine zweite Anschlusselektrode, die gebildet werden auf den externen Seiten des Substrats;
Erdungselektroden, die gebildet werden auf den externen Seiten des Substrats;

wobei
die Induktoren gebildet sind im Inneren des Substrats, angeordnet zwischen der ersten Anschlusselektrode und der zweiten Anschlusselektrode und umfassend Leiterfilme, die in einer Spiralform gebildet sind, und sich über eine Vielzahl von Lagen erstrecken; und
zwei oder mehr der Kondensatoren gebildet werden im Inneren des Substrats und angeordnet sind zwischen Zwischenpunkte der Induktoren, die voneinander unterschiedlich sind und den Erdungselektroden.

4. Das LC-Verbundteil nach Anspruch 1, wobei:

die Induktoren und Kondensatoren eine Tiefpass-LC-Filterschaltung darstellen; und
wenn eine Grenzfrequenz der LC-Schaltung bestimmt wird durch eine Darstellung fc, eine Induktivität von einem der Induktoren bestimmt wird durch eine Darstellung L und eine Kapazität von einem der Restkondensatoren pro Induktor äquivalent verbunden mit einem der Induktoren parallel bestimmt wird durch eine Darstellung C, der Restkondensator bereitgestellt wird mit der Kapazität, die das Folgende erfüllt:

$$\log(fc) + 0{,}6 \le \log\left\{1/2 \ (2\pi\sqrt{(LC)})\right\} \le \log(fc) + 1{,}5.$$

**Revendications**

1. Pièce composite LC comprenant :

   un substrat incorporant à la fois un matériau magnétique et un matériau diélectrique ;
   des inducteurs formés sur une partie intérieure du substrat présentant deux structures en spirale disposées l'une avec l'autre et connectées entre elles de telle sorte que les flux magnétiques aux parties intérieures des structures en spirale sont parallèles entre eux et dirigés dans des directions réciproquement inverses ; et
   des condenseurs comprenant des plaquettes planes parallèles entre elles, formés sur la partie intérieure du substrat, partie composite LC dans laquelle les condenseurs sont formés sur des positions prises en sandwich par les deux structures en spirale constituant les inducteurs.

2. Partie composite LC selon la revendication 1, dans laquelle l'une des plaquettes planes parallèles entre elles constituant les condenseurs sont connectées en des positions intermédiaires des inducteurs.

3. Pièce composite LC selon la revendication 1, comprenant de plus :

   une première et une seconde électrode terminales formées sur les faces extérieures du substrat ;
   des électrodes de masse formées sur les faces extérieures du substrat ;

   dans laquelle
   les inducteurs sont formés sur une partie intérieure du substrat, disposés entre la première électrode de terminal et la seconde électrode de terminal et comprenant des films conducteurs formés en spirale et s'étendant sur une pluralité de couches ; et
   deux ou plus de deux condenseurs sont formés sur la partie intérieure du substrat et disposés entre des points intermédiaires des inducteurs différents entre eux et les électrodes de masse.

4. Pièce composite LC selon la revendication 1, dans laquelle :

   les inducteurs et condensateurs constituent un circuit de filtre LC basse fréquence ; et
   lorsqu'une fréquence de coupure du circuit LC est désignée par une notation fc, une inductance de l'un des inducteurs est désignée par une notation L, et une capacitance de l'un des condensateurs résiduels par inducteur connecté de façon équivalente à l'un des inducteurs en parallèle est désignée par une notation C, le condensateur résiduel est doté de la capacitance satisfaisant l'équation suivante:

$$\log(fc) \ + \ 0{,}6 \ \le \ \log\{1/2 \ (2\pi\sqrt{(LC)})\} \ \le \ \log(fc) \ + \ 1{,}5.$$

# Fig.1

# Fig.2

# Fig.3

# Fig.4

# Fig.5

# Fig.6A

# Fig.6B

100

100

# Fig.7A

# Fig.7B

1a    1b    1c    100

1a    1b    1c

100

# Fig.8A

# Fig.8B

101

12a

12b

A

A

1a    1b   101  12b  1c   101

100

# Fig.9A

2a    2b    2c    101

# Fig.9B

1a   2a   1b   2b   2c   1c
101
100

# Fig.10A

102

23a
23b

# Fig.10B

2a   23a   2b   2c
102
101
100

# Fig.11A

3a    3b    3c    102

# Fig.11B

3a    3b    3c
102
101
100

Fig.12A

Fig.12B

Fig.13A

Fig.13B

Fig.14 A

Fig.14B

# Fig.15

# Fig.16

# Fig.17

Fig.18

A; C=733pF,L=669nH
B; C=909pF,L=139lnH

loss [dB] / frequency [Hz]

Fig.19

# Fig.20

**EP 0 836 277 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 8065080 A
- JP 8148381 A
- JP 08031695 A
- US 4904967 A
- US 5532656 A